Europäisches Patentamt

(19) European Patent Office

Office européen des brevets

(11) EP 0 841 704 A1

(12) EUROPEAN PATENT APPLICATION

(43) Date of publication:
13.05.1998 Bulletin 1998/20

(21) Application number: 97113111.5

(22) Date of filing: 30.07.1997

(51) Int. Cl.$^6$: H01L 29/15, H01L 29/36, H01L 29/778, H01L 29/775, H01L 21/335

(84) Designated Contracting States:
AT BE CH DE DK ES FI FR GB GR IE IT LI LU MC NL PT SE
Designated Extension States:
AL LT LV RO SI

(30) Priority: 07.11.1996 EP 96117884

(71) Applicant:
Paul-Drude-Institut für Festkörperelektronik
10117 Berlin (DE)

(72) Inventors:
• Friedland, K.-J., Dr.
12623 Berlin (DE)
• Hey, R., Dr.
12679 Berlin (DE)
• Kostial, H., Dr.
10117 Berlin (DE)
• Höricke, M.
16341 Schwanebeck (DE)
• Ploog, K.H., Prof. Dr.
15566 Schöneiche (DE)

(74) Representative:
Morgan, James G. et al
Robert-Koch-Strasse 1
80538 München (DE)

(54) Semiconductor transistor device and method of manufacturing the same

(57) A method of manufacturing a semiconductor transistor device on a substrate (10), with the transistor device comprising source and drain contacts (36, 38) to a conductive layer (24) extending between the contacts and at least one gate electrode (40) disposed adjacent to and spaced from the conductive layer, is characterized by the step of growing in sequence on said substrate a first superlattice (20), a quantum well layer (24) and a second superlattice (26), said first and second superlattices (20, 26) forming the barriers for the quantum well layer (24), and by the step of δ doping each of said first and second superlattices (20, 26) to form at least one δ doped layer (22, 28) therein, whereby to enhance the conductivity of the electrons in the quantum well layer (24). The transistor device is also claimed per se.

FIG. 3

EP 0 841 704 A1

## Description

The present invention relates to a method of manufacturing a semiconductor transistor device on a substrate, the device comprising source and drain contacts to a conductive layer extending between the contacts and at least one gate electrode disposed adjacent to and spaced from the conductive layer. Furthermore, the present invention relates to a semiconductor transistor device.

Semiconductor transistor devices such as FETs have been proposed in a large number of different forms. For example, US patent 4,882,609 discloses and claims an FET in which a two-dimensional conductive channel is formed as a quantum well at the boundary between two layers of different materials of different band gaps and is supplied with electrons by so-called $\delta$ doping of the layer having the layer band gap. In this design the source and drain contacts are realized as contacts to the active layer and the conductivity of the conductive channel formed by the quantum well is controlled by a top gate.

In an alternative embodiment the FET is provided with a superlattice structure comprising alternating layers of two materials having different band gaps and a $\delta$ doped layer is provided in each of the layers of smaller band gap.

US patents 5,396,089 and 5,338,692, which correspond to the European application with the publication number EP-A-394 757, disclose a novel and extremely interesting design for FETs using so-called in-plane gates. More specifically, a semiconductor substrate having a two-dimensional conductive layer formed by a two-dimensional electron gas is divided up to form lateral potential boundaries defining source, drain and gate regions. That is to say, the gate is formed by a portion of the two-dimensional electron gas itself, which is insulated from a conductive channel formed from the two-dimensional electron gas forming and extending between the source and drain regions. The lateral potential boundaries insulating the gate from the conductive channel and separating the source from the drain can be formed by a number of different methods, for example by ion implantation. Alternatively, it can be formed by etching trenches into the substrate as is described in US patent 5,385,865 and in the corresponding European application with the publication number EP-A-464 834.

Numerous attempts have been made to achieve ultrahigh conductivity in two-dimensional electron gas (2DEG) systems for both fundamental research and applications in low-noise, high-frequency devices. The most promising material systems are those which provide high potential barriers to confine the electron channel. In this respect reference can be made to the following papers:

G. Tränkle, H. Rothfritz, R. Müller and R. Weimann, J. Cryst. Growth **120**, 240 (1992)

T. Akazaki, J. Nitta, H. Takayanagi, T. Enoki and K. Arai, Appl. Phys. Lett. **65**, 1263 (1994)

W.T. Masselink, Phys. Rev. Lett. **66**, 1513 (1991)

N.L. Pfeiffer, K.W. West, J.P. Eisenstein, K.W. Baldwin and P. Gammel, Appl. Phys. Lett. **61**, 1211 (1992)

B.E. Kane, L.N. Pfeiffer and K.W. West, Appl. Phys. Lett. **67**, 1262 (1995)

M. Blumina, I.O. Lelong, R. Sarfaty and D. Fekete, J. Appl. Phys. **75**, 357 (1994)

High barriers allow for large 2DEG concentrations $n$. At the same time, the devices can operate at higher temperatures. However, the possibilities to increase the conductivity by simply increasing the dopant density are limited for several reasons. First, high dopant densities can result in a parallel conductivity of the 2DEG with electrons in the doping channel. Second, large carrier densities can lead to the population of excited subbands which cause an additional scattering channel (as described in the papers by R.A. Mena, S.E. Schacham, E.J. Haugland, S.A. Alterovitz, S.B. Bibyk and S.A. Ringel, J. Appl. Phys. **78**,3940 (1995). Third, and most important, a high dopant density increases the remote impurity scattering. All these mechanisms result in a lower electron mobility $\mu$. However, both a high mobility and a large carrier density are the prerequisite for a high conductivity $\sigma = q\,n\,\mu$, where $q$ denotes the elementary charge. In the following the product $n \times \mu$ will be used as a measure for the two-dimensional conductivity.

It will be appreciated that there are substantial difficulties involved in simultaneously obtaining a high electron mobility $\mu$ and a large carrier density $n$. However, both these parameters must be kept as large as possible if ultrahigh conductivity is to be obtained. Remote impurity scattering can be suppressed by increasing the distance of the dopants from the conducting channel as described in the papers by K. Suzuki, K. Saito, T. Saku, A. Sugimura, Y. Horikoshi and S. Yamada, J. Cryst. Growth **150**, 1266 (1995); by T. Saku, Y. Horikoshi and S. Tarucha, Jpn. J. Appl. Phys. **33**, 4837 (1994) and by S. Hiyamizu, J. Saito, K. Nanbu and T. Ishikawa, Jpn. J. Appl. Phys. **22**, L609 (1983), but this reduces the carrier densities. In the well-known (Al,Ga)As system high electron mobilities of several 100 m²/Vs at low temperatures have been reported. The systems consist of multi-quantum wells with low carrier densities of 0.64 x 10¹⁵ m⁻² per quantum well (see, for example, the above named paper by L.N. Pfeiffer, K.W. West, J.P. Eisenstein, K.W. Baldwin and P. Gammel, Appl. Phys. Lett. **61**, 1211 (1992)) or of inversion layers at single heterointerfaces with carrier densities up to 3 x 10¹⁵ m⁻² (see, for example, the above named paper by B.E. Kane, L.N. Pfeiffer and K.W. West, Appl. Phys. Lett. **67**, 1262 (1995)). In such high mobility samples the mobility is limited by interface roughness scattering in (Al,Ga)As system (as described in the paper by U. Bockelmann, G. Abstreiter, G. Weimann and W. Schlapp, Phys. Rev. B41,7864 (1990)) or by alloy disorder scattering in ternary systems (as described in the papers by A. Gold, Phys. Rev. B38, 10798 (1988)). The pseudomorphic (AlGa)/(InGa)As is another promising system to achieve high conductivities even at much higher temperatures. By optimizing the quantum well thickness and the dopant separation from the quantum well, conductivities approaching $n \times \mu = 9 \times 10^{16}$ (Vs)$^{-1}$ up to temperatures as high as 77 K have been reported (as described in the above named paper by M. Blumina, I.O. Lelong, R. Sarfaty and D. Fekete, J. Appl. Phys. **75**, 357 (1994)).

Despite the advances made in FETs of high conductivity (so-called HEMTs (high electron mobility transistors) and in single electron transistors, there is still a need to increase the electron density while retaining the high electron mobility, for example to provide a steeper current gain characteristic in FETs and a steeper charge distribution profile at the boundaries of low-dimensional structures, i.e. quantum wire or quantum dot structures and thus a higher separation of the quantized energy levels in order to reduce intersubband scattering.

It is the object of the present invention to provide semiconductor transistor devices and a method of manufacturing the same which provides for a high electron density and simultaneously high electron mobility in order to satisfy the above needs.

In order to satisfy this object there is provided a method of the initially named kind which is characterized by the step of growing in sequence on said substrate a first superlattice, a quantum well layer and a second superlattice, said first and second superlattices forming the barriers for the quantum well layer, and by the further step of δ doping each of said first and second superlattices to form at least one δ doped layer therein, whereby to enhance the conductivity of the electrons in the quantum well layer.

The semiconductor transistor device formed by this method is thus characterized by an active region formed on the substrate and comprising in sequence a first superlattice, a quantum well layer and a second superlattice, said first and second superlattices forming the barriers for the quantum well layer and by at least one δ doped layer in each of said first and second superlattices.

This method and device represent a new concept for the enhancement of both the carrier concentration and the reduction of remote impurity scattering (RIS) in single quantum wells (SQW), thereby significantly increasing the conductivity.

More specifically, it has been found that impurity scattering in remotely doped single quantum wells can be effectively reduced by the presence of heavy mass X-electrons in the short period superlattices in the direct vicinity of the dopant atoms in the barriers formed by the short period superlattices. These X-electrons exhibit an extremely high screening capability and are able to smooth the potential fluctuations caused by the random distribution of the dopants. They are strongly localized and do not contribute to the conductivity. In this way it has proved possible to increase the mobility by reducing the impurity scattering and to do so without reducing the electron density in the quantum well layer.

It is particularly preferred when the layers of each of the first and second superlattices consist of different elements or compounds, thereby increasing the barrier height and therefore the electron density in the quantum well.

By way of example the superlattices could consist of alternate layers of AlAs/GaAs, or GaN/AlGaN or GaN/SiC, or Ge/Si. They should not, however, consist of mixed crystals such as $Al_xGa_{1-x}As/GaS/GaS$ or $Ge_xSi_{1-x}/Si$ because with such mixed crystals the electrons are not localized in the quantum wells but rather distributed within the crystal.

The thickness of the barrier layers of the superlattice structures are preferably selected so that the electrons from the donors in the δ doped layers are localized in the neighboring barrier layers. This screens the fluctuations of the potential from the charge donors and other impurities or surface charges, thus reducing the scattering and in particular the ionized impurity scattering and therefore increases the mobility of the electrons in the quantum well layer.

The active region of the semiconductor device comprising the first and second superlattices and the quantum well layer are preferably made in a III-V or IV-IV material system, in particular in AlAs/GaAs or Ge/Si or GaN/AlGaN or GaN/SiC.

The quantum well layer can, however, advantageously comprise a mixed crystal. This makes it possible to depress the energy level of the quantum well and to thereby increase the quantum well density (i.e. the density of electrons in the quantum well). For example, in a device having an active region based on AlAS/GaAs, In can be added to the GaAs quantum well to make an InGaAs mixed crystal.

The active region of the transistor device can also be realized with advantage as a quantum dot or quantum wire structure. This leads to improved sharpness of the lateral profile of the electron distribution while retaining the high mobility.

This has the advantage that there are less DX centers and, moreover, the persistent photoconductive effect is negligibly small.

Further advantages of the invention will be apparent from the further description.

The invention will now be described in more detail by way of example only and with reference to the accompanying drawings in which are shown:

| | | | |
|---|---|---|---|
| Fig. 1 | a schematic drawing showing the basic layout of a semiconductor structure useful for the present invention, | structure of Fig. 15, | |
| Fig. 2 | a table giving full particulars of the layer structure of Fig. 1, | Fig. 17 | a view similar to Fig. 15 but showing a structure provided with three back gates, |
| Fig. 3 | a diagram showing the band structure and the electron density of the active region of the semiconductor structure of Figs. 1 and 2, | Fig. 18 | a view similar to Fig. 15 but showing a structure provided with two top gates and one back gate, |
| Fig. 4 | a schematic illustration of the semiconductor structure of Fig. 1 adapted to form an FET by the provision of a top gate, | Fig. 19 | a view similar to Fig. 15 but showing an alternative design with two top gates and one back gate, |
| Fig. 5 | a plan view of the semiconductor structure of Fig. 1 when used to realize an FET with an in-plane gate, | Fig. 20 | a quantum dot structure basically resembling Fig. 10 but provided with two in-plane gates, |
| Fig. 6 | a schematic view of the structure of Fig. 1 when used to realize an FET with the gate electrode being formed as a back gate, | Fig. 21 | a graph showing the magnetic field dependence of the resistances $\rho_{xx}$ and $\rho_{xy}$ at $T$ = 0.33 K for a first sample S1 (as defined in the table of Fig. 2), |
| Fig. 7 | a plan view of the semiconductor structure of Fig. 1, modified to generate a quantum well wire, | Fig. 22 | a table showing the peak mobilities, $\mu_H$, electron densities $n$ and $T1/Ts$ for two distances $d\Delta$ of the $\delta$ doping layer from an SQW interface in ungated samples S1 and S2 at $T$ = 0.33 K, |
| Fig. 8 | a plan view similar to Fig. 7, but showing the structure equipped with a top gate, | Fig. 23 | a graph showing the dependence of the electron mobility $\mu_H$ on the electron density $n_H$ obtained at $T$ = 0.33 K and B = 0.1 $T$ for the two samples S1 and S2 of the table of Fig. 22 using a gate, the single points of maximum mobility and both curves were measured on ungated samples, the thin lines represent a fit with the power k = 2, and |
| Fig. 9 | a view similar to Fig. 8 but showing the semiconductor structure equipped with a back gate, | | |
| Fig. 10 | a view similar to that of Fig. 7 but with the structure provided with two top gates to form a quantum dot structure, | | |
| Fig. 11 | a graph showing the electron carrier density n in the longitudinal direction of the structure of Fig. 10, | Fig. 24 | a graph showing the dependence of capacitances C,$C^{2D}$ and mobility $\mu_H$ on the gate voltage, the line which extrapolates the flat region of C is intended as a guide for the eye, it corresponds to the CV-characteristic without the X-band electrons. |
| Fig. 12 | a structure similar to that of Fig. 10 but provided with two back gates, | | |
| Fig. 13 | a view similar to that of Fig. 10 but showing a structure with two alternately configured top gates, | | |
| Fig. 14 | a view similar to that of Fig. 10 but provided with one top gate and one back gate, | | |
| Fig. 15 | a structure similar to that of Fig. 7 but provided with three top gates to define two quantum dots, | | |
| Fig. 16 | a graph similar to Fig. 11 but related to the | | |

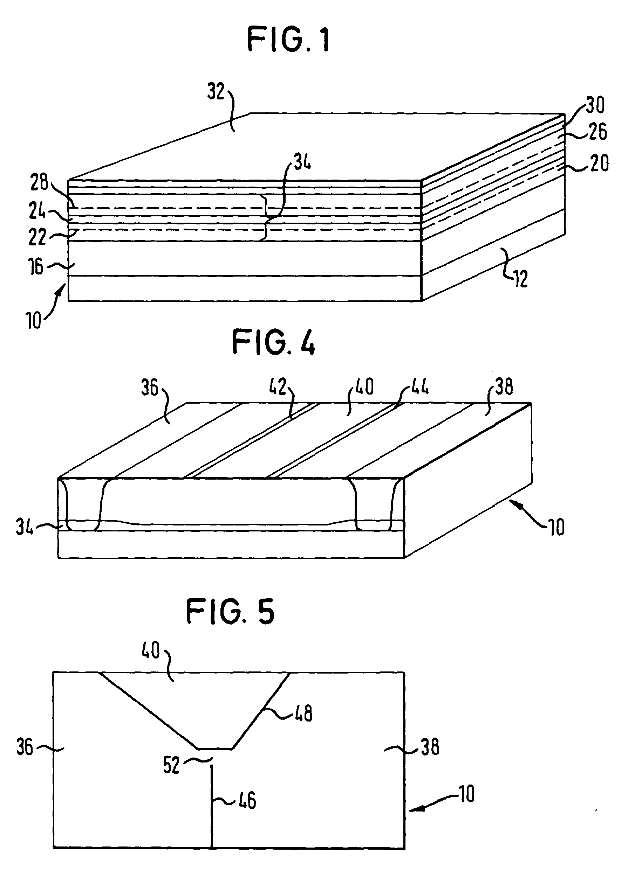

Turning first to Fig. 1, there is shown a schematic diagram of a semiconductor structure in accordance with the present invention. It is emphasized that the diagram is not to scale and more specifically the relative sizes of the layers illustrated in the diagram of Fig. 1 do not accurately reflect the relative sizes of the layers of the actual structure, which will be later described in more detail.

More specifically, Fig. 1 shows a semiconductor structure 10 comprising a semi-insulating substrate 12, for example of gallium arsenide. On top of this substrate 12 there is then grown a buffer layer 16, for example consisting of 500 nm of gallium arsenide, in order to prevent impurities and defects migrating from the substrate through to the overlying structure, and to ensure a sound crystallographic structure. On top of this layer 16 there is then grown a first superlattice system 20 consisting, in this example, of alternating layers of gallium arsenide and aluminum arsenide, for example with a total of sixty-three periods. These layers are essentially undoped, however, one of the gallium arsenide layers, i.e. the layer of the material with the lower band gap, is provided with a $\delta$ doped layer 22, i.e. a single doped monolayer. In this embodiment the dopant is silicon and the doping density is $2 \times 10^{12}$ cm$^{-2}$. It has been found beneficial if this $\delta$ doped layer is then followed by a further three and a half periods of the superlattice of alternating composition.

On top of this first superlattice structure there is then grown a single quantum well layer 24 and the quantum well layer 24 is grown in the material having the smaller band gap, i.e. in this example in gallium arsenide. The well layer 24 is undoped

On top of the quantum well layer 24 there is then grown a second superlattice structure 26, again comprising two layers of different materials, and indeed the same materials that are used for the alternating layers of the superlattice of the first superlattice structure 20.

Again one of the layers of the material having the lower band gap is subjected to $\delta$ doping to produce a second $\delta$ doped layer 28. Between the quantum well layer 24 and the second $\delta$ doped layer 28 there are preferably again provided three and a half periods of alternating composition. The total number of periods of the second superlattice structure is also sixty-three.

On top of the second superlattice structure 26 there is then grown a top layer 32 of the same material as the substrate but doped at a relatively high level to provide a layer of high conductivity. In the example shown here the top layer 32 comprises GaAs and is doped with silicon with a doping density of $1.5 \times 10^{18}$ cm$^{-3}$. It is also possible to include an etch stop layer 30 (e.g. of $Al_{0.23}Ga_{0.77}As$) between the second superlattice structure 26 and the top layer 32.

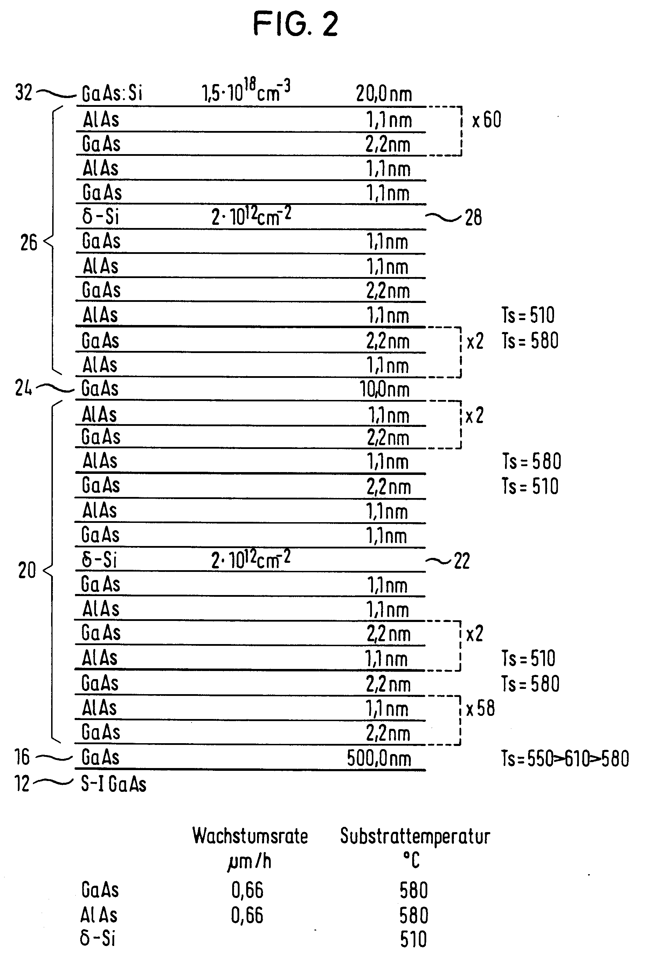

The precise layer structure and the growth rates and substrate temperatures as well as the doping densities can be seen from the table of Fig. 2. This table in fact gives the complete recipe for the production of the samples S1 which will be referred to later. It does not include an etch stop layer. The numbering of the layers shown in Fig. 1 has been entered in table 2 for the sake of clarity.

It will be noted that growth takes place in the vertical direction (upwardly in Fig. 2) and that the substrate temperature is reduced from $Ts = 580°C$ to $510°C$ after the first 58 ½ periods of the first superlattice so that the $\delta$ doping at the center of one of the GaAs layers takes place at the lower substrate temperature. This avoids unwanted diffusion of the silicon atoms. It can be seen that the reduced substrate temperature is used for a few periods of the superlattice on either side of the $\delta$ doped

layer 22. It is then increased again to $580°C$ for the growth of the final two periods of the first superlattice 20, for the growth of the quantum well layer 24 and for the growth of the first two periods of the second superlattice 26 before being reduced again for the growth remainder of the remainder of the structures including the second $\delta$ doped layer 28.

It will be noted that the example given here is the preferred example which has delivered the best results to date. However, the invention is not restricted to the gallium arsenide/ aluminum arsenide system but can, for example, readily be realized in any of the known III-V semiconductor systems or in IV-IV semiconductor systems. The first and second superlattice structures will generally always be formed by alternating layers consisting of different elements or of different compounds, for example, without restrictions, AlAs/GaAs, or Ge/Si or GaN/AlGaN or GaN/SiC. They will ordinarily not be mixed crystal layers, i.e. for example not $Al_xGa_{1-x}As$ or $Ge_xSi_{1-x}$. The single quantum well layer 24 can, however, consist of a mixed crystal material, for example InGaAs.

The total number of periods of the first and second superlattices, i.e. the total number of pairs of alternating layers, is not critical but would typically be of the order of 50 layers or so. The thickness selected for the individual layers of the superlattice structures are those typical for such structures.

The precise position of the $\delta$ doped layers 22 and 28 in the first and second superlattices 20 and 26 is also not critical. However, favorable results have been obtained if two or three periods of the superlattice are disposed between each $\delta$ doped layer 22, 28 and the single quantum well layer 24.

In the following discussion the region comprising the first and second superlattices 20, 26 with the $\delta$ doped layers 22 and 28 and the single quantum well layer 24 disposed between them will generally be referred to as the active region of the semiconductor structure. This active region is designated generally by the reference numeral 34.

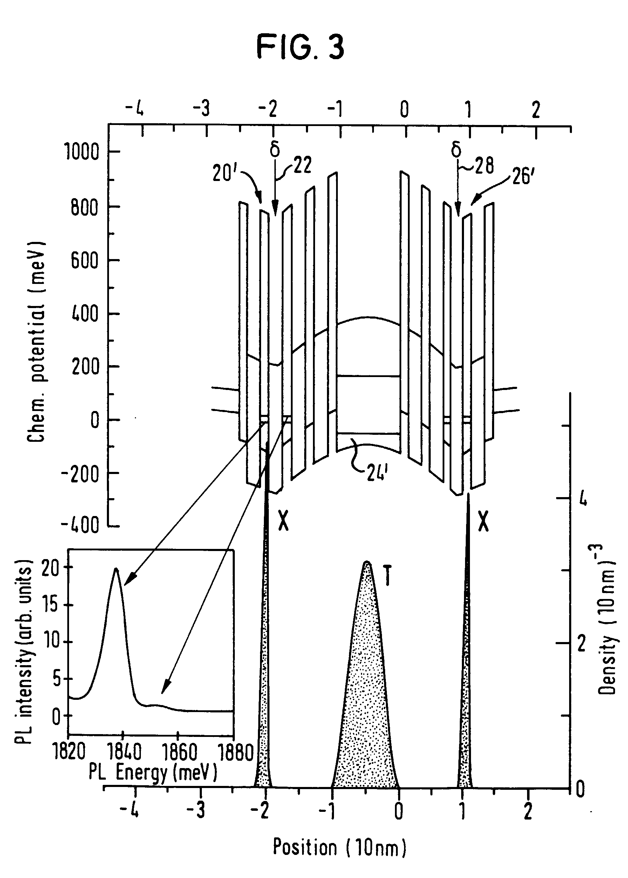

Fig. 3 shows the band structure for the active region 34 and is in fact a composite drawing showing both the band structure and the charge distribution of the electrons.

The theoretical background will be described later in more detail. It suffices here to say that the band diagram shows at the center the quantum well 24' formed by the single quantum well layer 24 in the structure of Fig. 1. On either side of this quantum well there can be seen the barriers 20' and 26' formed by the first and second superlattices 20 and 26 of Fig. 1. In fact the band diagram does not show all the periods of the first and second superlattices but rather only the last five and indeed it would be possible to restrict the total number of periods of the superlattices. The letter $\delta$ shows the position of the $\delta$ doped layers 22 and 28 of the structure of Fig. 1 and it will be noted that there are three and a half periods of the superlattice structure disposed between each δ doped layer 22, 28 and the quantum well 24' of the single quantum well layer 24. It will also be noted from the position of the arrows associated with the deltas that the position of each δ doped layer is disposed in the middle of the - otherwise undoped - material having the lower band gap, i.e. in the GaAs in the AlAs/GaAs system.

Although the dopant atoms (silicon in this example) used for the δ doping are localized in the middle of the respective layers, the electrons provided by these dopant atoms transfer into two energy levels in the two neighboring layers having the higher band gap. These two energy levels are illustrated by thin horizontal lines in Fig. 3 and the electron concentrations in these levels are indicated by the PL intensity plot shown in the inset square graph in the bottom left hand corner of Fig. 3.

The single quantum well 24' has two spaced apart energy levels - again shown by horizontal lines - of which only the lower energy level is normally occupied by electrons.

As will be explained later in more detail despite the non-uniform distribution of the dopant atoms in the δ doped layers, the X-electrons resulting from the dopants are localized and uniformly distributed in the quantized energy levels at the minima of the fluctuating potentials caused by the randomly distributed dopants. The X-electrons thus screen the electrons in the single quantum well 24' from the fluctuating potential caused by the randomly distributed dopants. It is this that is believed to enhance the mobility of the electrons in the quantum well 24' without disadvantageously affecting the electron density.

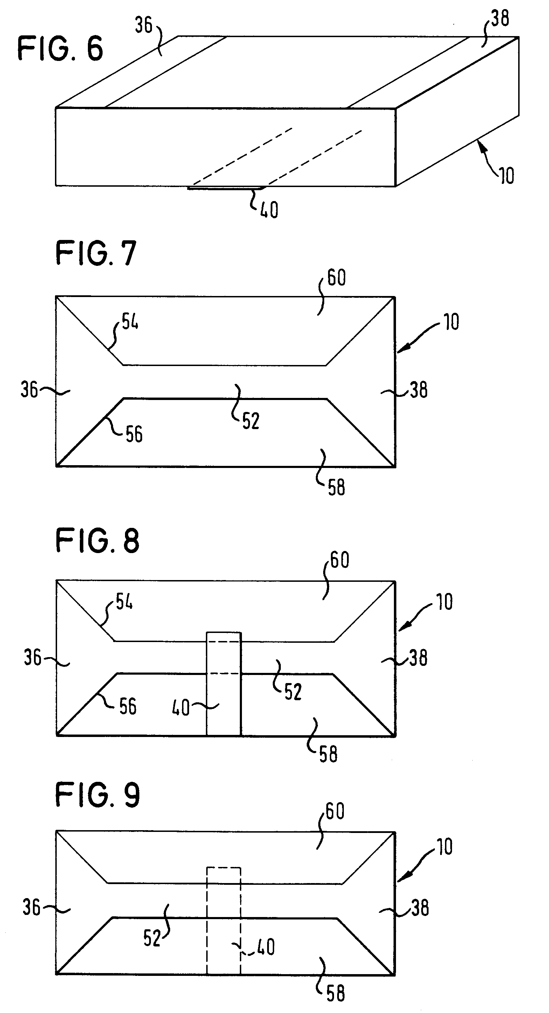

Turning now to Fig. 4 there is shown a first example of an FET formed using the semiconductor structure 10 of Fig. 1.

It will be noted that the substrate is provided with source and drain electrodes 36 and 38 respectively which extend through the semiconductor structure 10 and thus provide contacts to the active region 34 in particular.

Disposed between the source and drain electrodes 36 and 38 is a single gate electrode 40 which is spaced from the source and drain electrodes 36 and 38 and overlies the 2DEG provided in the quantum well layer 24. The top gate 40 is achieved by etching away a central strip portion of the top layer 32 (down to the etch stop layer 30) and by depositing a metallic gate layer on top of the etch stop layer 30. On either side of the top gate 40 there is a narrow window 42, 44 to avoid contact with the highly conductive top layer 32 present between the electrodes 36 and 38. These windows can, for example, be produced by ion beam etching.

The structure shown in Fig. 4 will immediately be recognized as an FET structure and the conduction between the source and drain electrodes can be controlled via the potential applied to the gate electrode 40.

Fig. 5 shows a different way of realizing an FET structure on the same substrate. Here the substrate is divided into source 36, drain 38 and gate regions 40 by ion implantation along the lines 46 and 48. The structure will be recognized by the person skilled in the art as a typical in-plane gate structure as shown in EP-A-394,757. The insulating regions formed by ion implantation along the lines 46 and 48 defining high quality insulating regions, i.e. lateral potential boundaries, which extend perpendicular to the plane of the substrate down through the active region 34. Reference numeral 52 denotes the conductive channel of the FET realized in this manner. As an alternative to forming the lateral potential boundaries 46 and 48 by ion implantation, which could be done with a focused ion beam system or with an extended ion beam and a mask, it is also possible to realize the regions 46 and 48 as trenches by an etching technique as disclosed in EP-A-464 834. The trenches so formed could also be filled with an insulator if desired.

Fig. 6 shows an alternative way of realizing an FET similar to the FET of Fig. 4. In this case the gate 40 is not formed as a top gate but as a back gate. In this Figure, as in all other Figures, the same reference numerals are used to denote the same parts or parts having the same function so as to avoid the need to describe each embodiment in great detail.

Fig. 7 shows an alternative starting point for forming an FET using the basic semiconductor structure 10. In this case the FET is provided with a conductive channel in the form of a quantum wire 52. This quantum wire 52 in fact comprises an elongate section of the 2DEG formed in the substrate 10. This elongate section can be realized in a variety of ways.

First of all, the boundaries 54 and 56 could be realized by ion implantation or etching in the manner described with respect to Fig. 5. Alternatively, the regions 58 and 60 could be realized as a split gate arrangement. By controlling the potentials applied to the regions 58 and 60, the regions of the quantum well layer beneath the gates can be depleted of electrons so that only the conductive region 52 remains.

Alternatively, the semiconductor structure 10 can be etched away in the regions 58 and 60 to a level beneath the active region 34 so that only a narrow web of active region remains, which defines the quantum well wire 52.

As shown by the reference numerals 36 and 38 the source and drain regions are contacts to the 2DEG at either end of the quantum wire. The gate for controlling the conductivity in the quantum wire 52 can be realized in different ways, as shown in the Figs. 8 and 9.

In Fig. 8 the gate 40 is realized as a top gate. This would, for example, be possible if the regions 58 and 60 were removed by etching.

In Fig. 9 the gate 40 is realized as a back gate and this would be possible with all the above explained ways of realizing the structure of Fig. 7.

Although, for the sake of illustration, the FET has been realized with a single quantum well wire 52, it would also be possible to provide a plurality of quantum well wires connecting the source and drain regions 36 and 38 if desired.

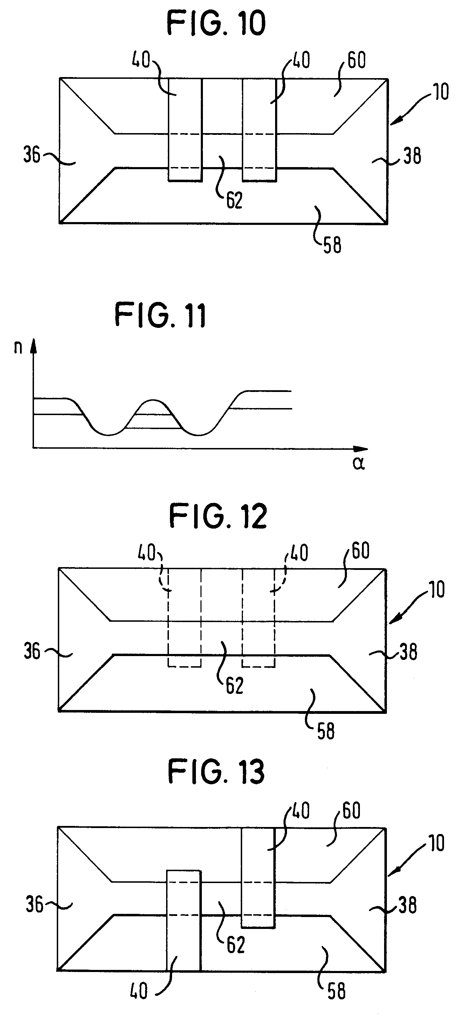

Fig. 10 now shows a further development of the concept explained with respect to Figs. 7 and 9, in which a quantum dot structure is realized by providing two gates 40 spaced apart along the length of the quantum well wire. The quantum dot 62 is defined by the region between the gate electrodes.

Fig. 11 shows the charge carrier distribution along the conductive channel between the source and drain regions 36 and 38 for the quantum dot structure of Fig. 10. By controlling the potentials applied to the two gates 40 it is possible to control the conduction of electrons through the channel, i.e. from the source electrode 36 into the energy levels of the quantum dot 62 and out of the energy levels of the quantum dot to the drain 38.

Fig. 12 shows two gates 40 which can also be realized as back gates.

Fig. 13 shows that it may be more convenient to lead the gate connections out to opposite sides of the semiconductor structure 10. In this case the gates are both realized as top gates; they could alternatively also be realized as back gates (not shown).

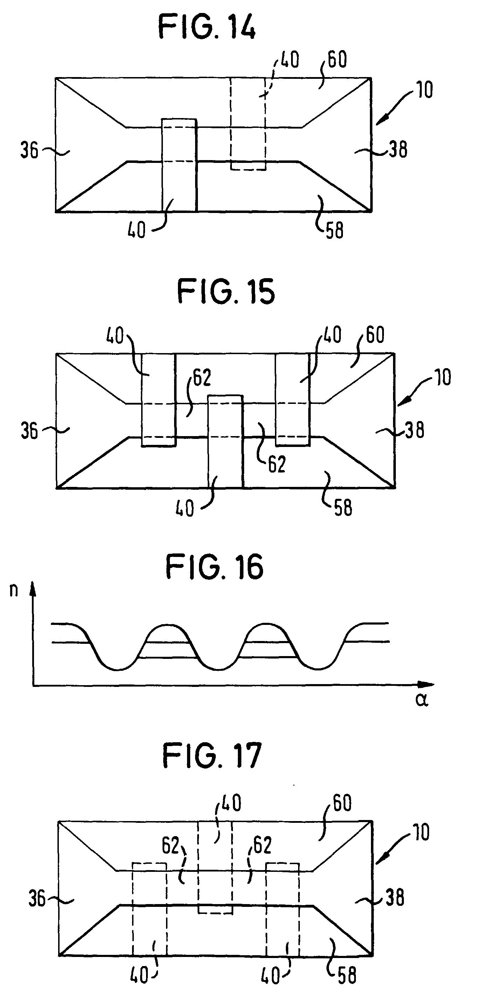

Alternatively, as shown in Fig. 14, one gate 40 could be realized as a top gate and one gate 40 as a back gate.

The invention is not, however, restricted to a single quantum dot. It could, for example, be realized with a plurality of quantum dots (for example with two quantum dots, as shown in Fig. 15). Here one again sees the same basic structure as in Fig. 7, but the structure is now provided with three gate electrodes 40 in order to provide two quantum dots 62.

The density of charge carriers along the conductive channel is shown schematically in Fig. 16.

Fig. 17 shows that the three gate electrodes 40 could also be realized as back gates.

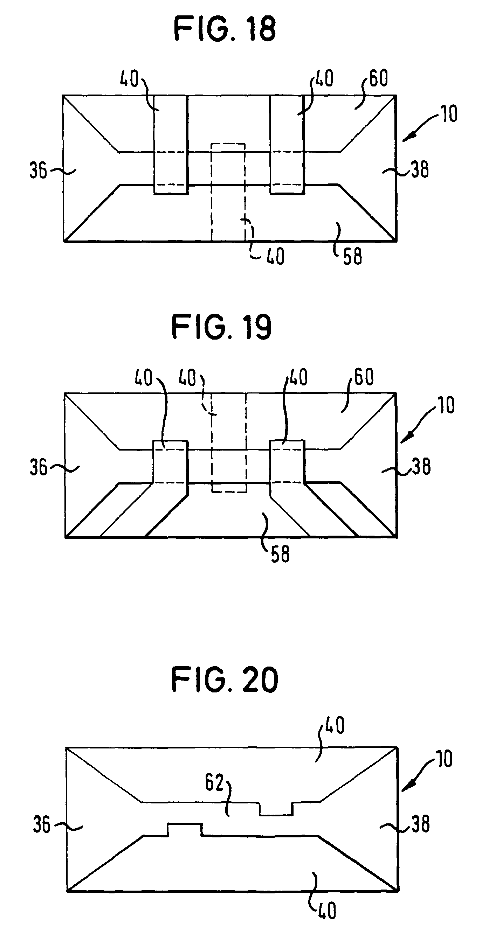

They could also be realized, as shown in Fig. 18, by one back gate and two top gates, alternatively by two back gates and one top gate (not shown).

Fig. 19 simply shows an arrangement similar to Fig. 18, but in which the contacts to the two outer gates are led divergently away from each other, which can be beneficial with regard to the very small dimensions of the devices.

Fig. 20 shows an alternative way of realizing a single dot structure 62, using the split gate arrangement of Fig. 7 as in-plane gates 40.

The theoretical background of the present invention and the results of some practical measurements will now be described in further detail with reference to the Figs. 3 and 21 to 24.

As noted above, the barriers of the GaAs SQW are formed by AlAs/GaAs short-period superlattices (SPSL). In AlAs/GaAs SPSLs the lowest conduction band state can be formed by the X-conduction band state of the AlAs layer, as described by M. Holtz, R. Cingolani, K. Reimann, R. Muralidharan, K. Syassen and K. Ploog, Phys. Rev. B$41$, 3641 (1990)(X-electron). Self consistent calculations show that with sufficiently high dopant densities the lowest energy X-like conduction band states are occupied in the AlAs/GaAs superlattice with the X-electrons located close to the doping layer. Due to their rather high effective mass, the X-electrons effectively screen the ionized impurities. Furthermore, the heavy mass X-electrons exhibit a low mobility and therefore are expected to contribute less to the parallel conductance. Magnetotransport experiments have confirmed the applicability of this concept.

The structures under investigation were grown by solid source molecular beam epitaxy on semi-insulating GaAs (001) substrates. The barriers consist of a SPSL of 60 periods of 4 monolayer AlAs and 8 monolayer GaAs. The carriers in the 10 nm GaAs SQW are provided by remote $\delta$ doping with Si at a distance from the SQW interface of 14 nm (sample S1) and 10 nm (sample S2). The single Si $\delta$ doping sheets with a dopant concentration of $N^{2D} = 2.5 \times 10^{16}$ m$^{-2}$ were placed on both sides of the SQW into a GaAs layer of the SPSL. The growth temperature of the lower barrier and the SQW was 580°C, whereas the temperature for the $\delta$ doping sheet and its vicinity was 510°C to suppress Si segregation into the well. The growth rate and the beam equivalent As$_4$-to-Ga pressure ratio were 0.66 $\mu$m/h and 8 respectively. The observed (2x4) surface reconstruction during the SPSL and SQW deposition reflects the two-dimensional nucleation growth mode, which was monitored by additional experiments.

The low-temperature magnetotransport properties of samples with a Hall-bar geometry were studied. Some of the samples were covered by a Ti/Au gate electrode. The gate was used to change the electron density and to investigate the electronic structure by voltage-dependent capacitance (CV) measurements. In all measurements the magnetic field was applied perpendicular to the surface.

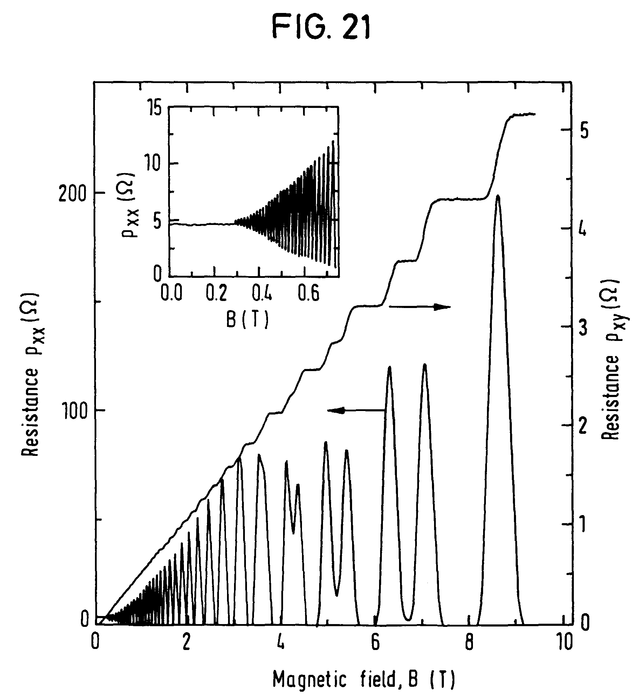

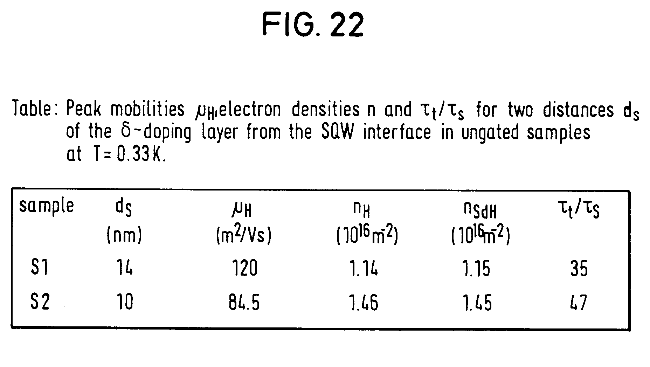

The main result of the investigations is the simultaneous observation of a very high mobility and very high electron densities. Fig. 21 shows the dependence of the parallel $\rho_{xx}$ and transverse $\rho_{xy}$ components of the resistivity tensor on the magnetic field. The electrons occupy only one subband which is manifested by Shubnikov-de-Haas (SdH) oscillations with only one frequency of the corresponding $\sigma_{xx}$ component of the conductivity tensor up to the highest gate voltages. The procedure described by J.P. Harrang, R.J. Higgins, R. K. Goodall, P.R. Jay, M. Laviron and P. Delescluse, Phys. Rev. B32, 8126 (1985) was used to derive the electron densities $n_{SDH}$ from the SdH frequency according to $\sigma_{xx} \approx \sigma_{osc}(2\pi \, E_1/\text{hw}_C)$. Here $E_1$ denotes the Fermi energy and $w_c$ is the cyclotron frequency. The prefactor $\sigma_{osc}$ contains information about the single particle relaxation time $\tau_s$. In the table of Fig. 22 the highest electron densities $n_{SDH}$ are listed for the samples without any gate electrode. These values are in excellent agreement with the carrier densities $n_H$ calculated front the low field Hall-effect $\rho_{xy} = \gamma/(e\,n_H)$ using the Hall-factor $\gamma = 1$. Together with the exact value

$$\rho_{xy}^{\upsilon} = h/(e^2 \upsilon)$$

and

$$\rho_{xx}^{\upsilon} = 0$$

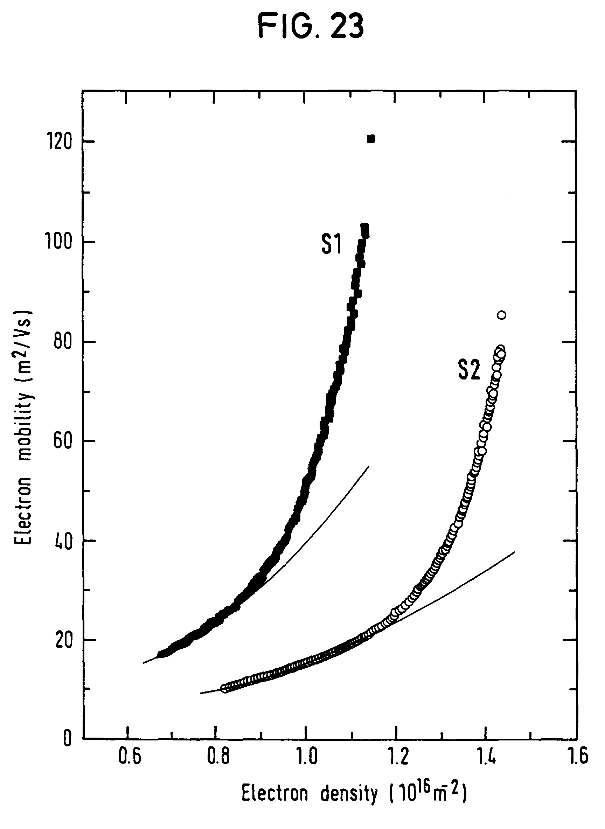

in the quantum Hall regime for the integer filling factor $\upsilon$, these results demonstrate the absence of any parallel conductance in the doping region. Therefore the Hall mobilities of the 2DEG can be determined as $\mu_H = \rho_{xy}/\rho_{xx}$ at low magnetic fields. The dependence of $\mu_H$ on the electron density $n_H$ will now be discussed with reference to Fig. 23, which appears to be very unusual. While a power-like dependence $\mu_H \approx (n_H)^k$ with $1.5 < k < 2$, is observed at lower densities (for example $n_H < 0.95 \times 10^{16}$ m$^{-2}$ in sample S1), the mobility increases much more strongly up to 120 m$^2$/Vs for $n_H > 0.95 \times 10^{16}$ m$^{-2}$ within a very narrow electron density region. In this range the exponent k reaches values exceeding 8. The power $1.5 < k < 2$ at lower densities is usually related to the remote impurity scattering (RIS) by randomly distributed impurities in the doping plane as described by A. Gold, Phys. Rev. B**38**, 10798 (1988) and by K. Hirakawa and H. Sakaki, Phys. Rev. B33, 8291 (1986). The much larger value in the high mobility region is difficult to model by scattering theories based on random potentials. To speculate about the scattering mechanism in this region the value of the scattering time ratio $\tau_t/\tau_s$ (STR) was investigated. The transport scattering time $\tau_t$ is calculated according to $\tau_t = (m_{eff}/e)\mu_H$. The STR for the highest mobilities is listed in the table of Fig. 22. No significant change of STR with electron density was observed. This behavior as well as the value of STR is characteristic for RIS. The lower value of the STR for sample S1 (cf. the table of Fig. 22) can be explained by the increasing weight of interface roughness scattering in SQWs with larger distances. The dominance of the RIS from the slight increase of the conductivity with increasing temperature has also been deduced. The maximum conductivity $n \times \mu = 1.35 \times 10^{18}$ (Vs)$^{-1}$ and $4.20 \times 10^{17}$ (Vs)$^{-1}$ were found at temperatures of 0.3 K and 77 K respectively. These values are comparable to the highest conductivities reported in SQWs at low temperatures, T < 1 K (see, for example, the paper by L.N. Pfeiffer, K.W. West, J.P. Eisenstein, K.W. Baldwin and P. Gammel, Appl. Phys. Lett. **61**, 1211 (1992) and B.E. Kane, L.N. Pfeiffer and K.W. West, Appl. Phys. Lett. **67**, 1262 (1995)).

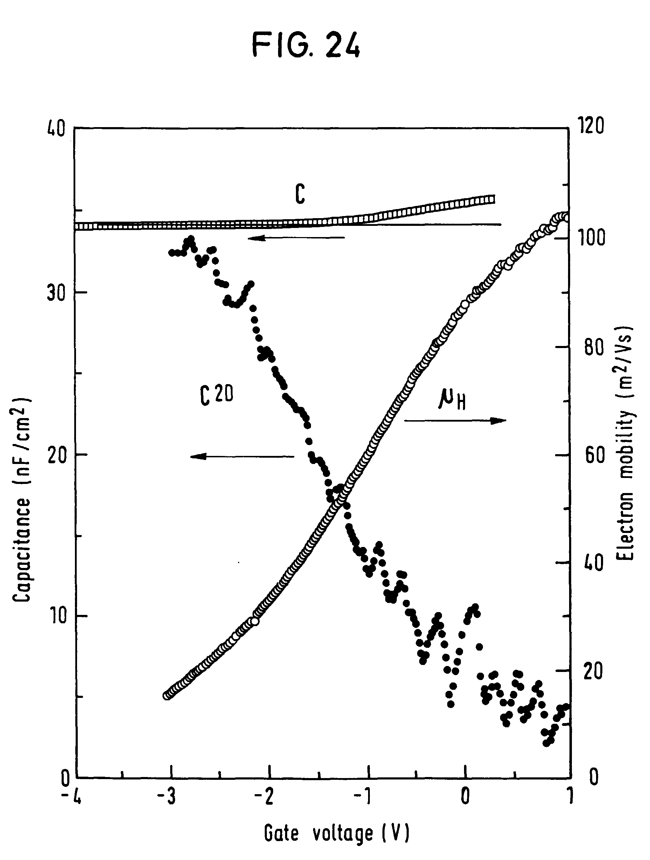

The conductivity at 77 K is even several times higher than any value so far reported in 2DEGs (see the paper by M. Blumina, I.O. Lelong, R. Sarfaty and D. Fekete, J. Appl. Phys. **75**, 357 (1994)). To explain the enhanced mobility in accordance with the present invention a RIS model was considered with a scattering potential with reduced fluctuation. The model was adapted to take into account additional carriers with low mobility in the SPSL very close to the doping layers. As proof of the existence of these carriers reference may be made to Fig. 24 which shows the dependence of the ac capacitance C determined with a 100 kHz excitation and $C^{2D} = \Delta n_H/\Delta U_g$ on the gate voltage $U_g$. While C is sensitive to all the rechargeable carriers in the system, $C^{2D}$ carries information only from carriers in the high mobility 2DEG. The relatively flat region of C at lower gate voltages $U_g < -1.5$ V corresponds to the depletion of the electrons in the SQW. The higher capacitance at $U_g > -1.5$ V and the vanishing of $C^{2D}$ in the same gate voltage region indicate the presence of additional carriers outside the SQW nearby the doping layer. The strong increase of the electron mobility takes place in the same gate voltage region and is, therefore, related to the existence of these carriers.

To clarify the nature of the additional carriers, Fig. 3 shows the results of model calculations of the potential and charge distribution in the new structure. The calculations are performed by the one-dimensional self consistent solution of the Schrödinger and Poisson equations in the effective mass approximation including exchange and correlation interaction energy. These calculations account for two different kinds of electrons. First, the usual $\Gamma$ electrons are considered with the isotropic effective mass $m_\Gamma/mc = 0.07$ which form the 2DEG ground subband. These electrons with high mobility are located in the SQW. The edge of the higher $\Gamma$ electron subbands in the SQW as well as in the SPSL are more than 170 meV above the Fermi energy. Therefore, they cannot be occupied at low temperatures. The possible maximum density for the conductivity with a single subband occupation is not yet known. Model calculations show that this value can be much higher than $2 \times 10^{16}$ m$^{-2}$. Second, the higher conduction band minima of the AlAs/GaAs-SPSL system have to be included into the calculation. It is known from experiments with AlGaAs/AlAs multiple quantum wells, as described in the paper by S. Yamada, K. Maezawa, W.T. Yuen and R.A. Stradling, Physica B,295 (1994), that at AlAs thicknesses $d_{AlAs} < 3$-4 nm the so-called $X_z$ electrons govern the transport properties.

These are electrons with an in-plane effective mass of about $m_{eff}/m_0 = 0.25$, while the heavy mass component $m_{xl}/m_e = 1.1$ in AlAs accounts for the subband quantization. Calculations show that the $X_z$ states are occupied first. The perpendicular states, the so-called $X_{xy}$ states, are well above the Fermi energy and can not be occupied by electrons at low temperatures. Due to the high quantization energy the influence of biaxial compressive stresses and intermixing effects can be neglected. These may, however, be important for much wider AlAs quantum wells, as described in the papers by T.S. Lay, J.J. Heremans, Y.W. Suen, M.B. Santos, K. Hirakawa, M. Shayegan and A. Zrenner, Appl. Phys.

Lett. **62**, 3120 (1993). The calculations made to date do not account for any spatial lateral fluctuations in the SPSL, but show quantitatively that in the system the X-electrons appear in the AlAs layer closest to the $\delta$ doped GaAs layer. Their quantity and spatial distribution, however, depend sensitively on the interface structure and the lateral potential fluctuations. It is assumed that the additional carriers detected in the CV measurements of Fig. 24 are X-electrons near the $\delta$ doping layer, which, however, do not contribute to the conductivity. The concentration of these carriers, which strongly depends on the gate voltage, can be estimated from CV measurements to have a maximum value of a few $10^{15}$ m$^{-2}$.

The results show conclusively that with X-electrons in the SPSL the mobility of the electrons in the GaAs SQW is considerably increased. The explanation can be confirmed by calculations which show that the X-electrons are located in the AlAs layer on one side of the doped GaAs layer in the SPSL (cf. Fig. 3). Their expected Bohr-radius $a^X_B \approx$ 2-3 nm as well as their nominal distance from the doping layer $d \approx 1.7$ nm is considerably smaller than the average distance between the Si dopant atoms $d_D = 1/\sqrt{N_D} \approx 8.9$ nm. Therefore, the X-electrons can be very easily localized at the minima of the fluctuating potential caused by the randomly distributed dopants. This localization explains the absence of any measurable parallel conductivity originating from the X-electrons in the magnetotransport experiments. Moreover, it is known that the additional localization effects take place in systems with disorder at high magnetic fields (see the papers by A. Zrenner, F. Koch, J. Leontin, M. Goiran and K. Ploog, Semic. Sci. Technol. 3, 1132 (1988). The effective mass of the X-electrons result in a screening parameter which is several times higher than that of the $\Gamma$-electrons. Therefore the X-electrons screen the fluctuating potential of the ionized Si impurities more effectively and selectively, leading to an increase of the mobility of the $\Gamma$-electrons in the GaAs SQW. This effect is expected to be similar to the mobility enhancement by an increasing correlation in the spatial distribution of the impurities, as described in the papers by T. Suski, P. Wisniewski, L.H. Dmovski, I. Gorczyca, J. Smoliner, E. Gornik G. Böhm and G. Weiman, Solid-State-Electronics 37, 677 (1994).

To study the energy spectrum of the X-electrons, photoluminescence (PL) measurements were carried out. In all samples tested the PL-spectra for the type II recombination region show a double peaked band (see inset of Fig. 3). This structure follows directly from the subband splitting of the X electrons in the SPSL, which is caused by the electric field of the separated X- and $\Gamma$-electrons. The indirect recombination is possible from AlAs layer on both sides the GaAs layer with a small energy difference. According to calculations this subband splitting with an energy separation of nearly 20 meV depends weakly on the position and the doping density (cf. Fig. 3). This splitting is close to the observed peak separation in the PL. The higher density of X-electrons at the lower energy sublevel explains the higher intensity of the low energy side peak in the PL spectra.

In conclusion it has been shown that impurity scattering in remotely doped GaAs single quantum wells (SQW) can be effectively reduced by the presence of heavy mass X-electrons within the AlAs/GaAs SPSL in the direct vicinity of the dopant atoms in the barrier. These X-electrons exhibit an extremely high screening capability and are able to smooth the potential fluctuations caused by the random distribution of the dopants. They are strongly localized and do not contribute to the conductivity. Investigations of the voltage dependent capacitance and of the photoluminescence as well as self consistent calculations confirm the existence of X-electrons in the AlAs/GaAs SPSL barriers.

It will be noted that although the measurements to date have been made with samples at low temperatures, it is also possible that the effect will persist at higher temperatures, e.g. at room temperature, particularly with further refinement of the design parameters and semiconductor materials used.

## Claims

1. Method of manufacturing a semiconductor transistor device on a substrate (10), the transistor device comprising source and drain contacts (36, 38) to a conductive layer (24) extending between the contacts and at least one gate electrode (40) disposed adjacent to and spaced from the conductive layer, characterized by growing in sequence on said substrate a first superlattice (20), a quantum well layer (24) and a second superlattice (26), said first and second superlattices (20, 26) forming the barriers for the quantum well layer (24), and by $\delta$ doping each of said first and second superlattices (20, 26) to form at least one $\delta$ doped layer (22, 28) therein, whereby to enhance the conductivity of the electrons in the quantum well layer (24).

2. Method in accordance with claim 1, characterized in that the layers of each of said first and second superlattices (20, 26) are made of different elements or compounds, for example AlAs/GaAs, or Ge/Si, or GaN/AlGaN, or GaN/SiC, thereby increasing the barrier height and therefore the electron density in the quantum well layer (24).

3. Method in accordance with claim 1 or claim 2, characterized in that the thickness of the barrier layers of the superlattice structures (20, 26) are selected so that some of the electrons from the donors in the $\delta$ doped layers (22, 28) are localized in the neighboring barrier layers, thus increasing the mobility of the electrons in the quantum well layer (24).

4. Method in accordance with any one of the preceding claims, characterized in that the active region (34) of the semiconductor device comprising the first and second superlattices (20, 26) and the quantum well layer (24) is made in a III-V or IV-IV material system, in particular in AlAs/GaAs or Ge/Si, or GaN/AlGaN or GaN/SiC.

5. Method in accordance with any one of the preceding claims, characterized in that the quantum well layer (24) is made as a mixed crystal in order to depress the energy level of the quantum wall and thereby increase the carrier density in the quantum well layer (24), for example, in a device having an active region based on AlAs/GaAs, by the addition of indium to the GaAs quantum well layer (24).

6. Method in accordance with any one of the preceding claims, characterized in that the active region (34) of the device is realized as a quantum dot or quantum wire structure (52, 62) with improved sharpness of the lateral profile of the electron distribution while retaining the high mobility.

7. Semiconductor transistor device formed on a substrate (10) and comprising source and drain contacts (36, 38) to a conductive layer (24) extending between the contacts (36, 38) and at least one gate electrode (40) disposed adjacent to and spaced from the conductive layer, characterized by an active region (34) formed on the substrate and comprising in sequence a first superlattice (20), a quantum well layer (24) and a second superlattice (26), said first and second superlattices (20, 26) forming the barriers for the quantum well layer (24) and by at least one $\delta$ doped layer (22, 28) in each of said first and second superlattices (20, 26).

8. Semiconductor transistor device in accordance with claim 7, characterized in that the layers of each of said first and second superlattices (20, 26) are made of different elements or compounds, for example AlAs/GaAs, or Ge/Si, or GaN/AlGaN, or GaN/SiC, thereby increasing the barrier height and therefore the electron density in the quantum well layer (24).

9. Semiconductor transistor device in accordance with claim 7 or claim 8, characterized in that the thickness of the barrier layers of the superlattice structures (20, 26) are selected so that some of the electrons from the donors in the $\delta$ doped layers (22, 28) are localized in the neighboring barrier layers, thus increasing the mobility of the electrons in the quantum well layer (24).

10. Semiconductor transistor device in accordance with any one of the claims 7 to 9, characterized in that the active region (34) of the semiconductor device comprising the first and second superlattices (20, 26) and the quantum well layer (24) are made in a III-V or IV-IV material system, in particular in AlAs/GaAs or Ge/Si, or GaN/AlGaN or GaN/SiC.

11. Semiconductor transistor device in accordance with any one of the claims 7 to 10, characterized in that the quantum well layer (24) is made as a mixed crystal in order to depress the energy level of the quantum well and thereby increase the carrier density in the quantum well layer (24), for example, in a device having an active region based on AlAs/GaAs, by the addition of indium to the GaAs quantum well layer (24).

12. Semiconductor transistor device in accordance with any one of the claims 7 to 11, characterized in that the active region (34) of the device is realized as a quantum dot or quantum wire structure (52, 62) with improved sharpness of the lateral profile of the electron distribution while retaining the high mobility.

13. Semiconductor transistor device in accordance with claim 12, wherein lateral potential boundaries (46, 48; 58, 60) are provided on either side of said active region by lithography and etching or by ion implantation or by a split gate arrangement and that a control gate (40) is provided to control the electron density in the channel (52) formed in the active region (34) between the lateral potential boundaries, with said control gate (40) being executed either as a top gate, or as a back gate, or as an in-plane gate.

14. Device in accordance with claim 13, characterized in that it comprises at least first and second control gates (40) spaced apart along said channel, thereby forming a quantum dot structure (62) from the quantum wire (52) defining said channel, with said first and second control gates (40) being either top gates or back gates or in-plane gates or a combination thereof.

FIG. 1

FIG. 4

FIG. 5

# FIG. 2

| 32 | GaAs:Si | $1{,}5 \cdot 10^{18} \text{cm}^{-3}$ | 20,0 nm | |
|---|---|---|---|---|
| | AlAs | | 1,1 nm | ] x60 |
| | GaAs | | 2,2 nm | ] |
| | AlAs | | 1,1 nm | |
| | GaAs | | 1,1 nm | |
| | δ-Si | $2 \cdot 10^{12} \text{cm}^{-2}$ | | ~28 |
| 26 | GaAs | | 1,1 nm | |
| | AlAs | | 1,1 nm | |
| | GaAs | | 2,2 nm | |
| | AlAs | | 1,1 nm | Ts = 510 |
| | GaAs | | 2,2 nm | ] x2   Ts = 580 |
| | AlAs | | 1,1 nm | ] |
| 24 | GaAs | | 10,0 nm | |
| | AlAs | | 1,1 nm | ] x2 |
| | GaAs | | 2,2 nm | ] |
| | AlAs | | 1,1 nm | Ts = 580 |
| | GaAs | | 2,2 nm | Ts = 510 |
| | AlAs | | 1,1 nm | |
| | GaAs | | 1,1 nm | |
| 20 | δ-Si | $2 \cdot 10^{12} \text{cm}^{-2}$ | | ~22 |
| | GaAs | | 1,1 nm | |
| | AlAs | | 1,1 nm | |
| | GaAs | | 2,2 nm | ] x2 |
| | AlAs | | 1,1 nm | ]   Ts = 510 |
| | GaAs | | 2,2 nm | Ts = 580 |
| | AlAs | | 1,1 nm | ] x58 |
| | GaAs | | 2,2 nm | ] |
| 16 | GaAs | | 500,0 nm | Ts = 550>610>580 |
| 12 | S-I GaAs | | | |

| | Wachstumsrate µm/h | Substrattemperatur °C |
|---|---|---|
| GaAs | 0,66 | 580 |
| AlAs | 0,66 | 580 |
| δ-Si | | 510 |

# FIG. 3

FIG. 6

FIG. 7

FIG. 8

FIG. 9

# FIG. 10

# FIG. 11

# FIG. 12

# FIG. 13

## FIG. 14

## FIG. 15

## FIG. 16

## FIG. 17

# FIG. 18

# FIG. 19

# FIG. 20

# FIG. 21

# FIG. 22

Table: Peak mobilities $\mu_H$, electron densities n and $\tau_t/\tau_s$ for two distances $d_s$ of the δ-doping layer from the SQW interface in ungated samples at T = 0.33 K.

| sample | $d_s$ (nm) | $\mu_H$ (m$^2$/Vs) | $n_H$ ($10^{16}$ m$^{-2}$) | $n_{SdH}$ ($10^{16}$ m$^{-2}$) | $\tau_t/\tau_s$ |
|---|---|---|---|---|---|
| S1 | 14 | 120 | 1.14 | 1.15 | 35 |
| S2 | 10 | 84.5 | 1.46 | 1.45 | 47 |

# FIG. 23

# FIG. 24

## EUROPEAN SEARCH REPORT

| | European Patent Office | | | Application Number EP 97 11 3111 |
|---|---|---|---|---|

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| P,X | FRIEDLAND K -J ET AL: "New concept for the reduction of impurity scattering in remotely doped GaAs quantum wells" PHYSICAL REVIEW LETTERS, 25 NOV. 1996, APS, USA, vol. 77, no. 22, ISSN 0031-9007, pages 4616-4619, XP002044440 * the whole document * | 1-14 | H01L29/15 H01L29/36 H01L29/778 H01L29/775 H01L21/335 |
| X | PATENT ABSTRACTS OF JAPAN vol. 011, no. 217 (E-523), 14 July 1987 -& JP 62 035678 A (FUJITSU LTD), 16 February 1987, | 1-5,7-11 | |
| Y | * abstract * | 6,12-14 | |
| X | PATENT ABSTRACTS OF JAPAN vol. 011, no. 363 (E-560), 26 November 1987 -& JP 62 136882 A (FUJITSU LTD), 19 June 1987, * abstract * | 1 | |
| D,Y | EP 0 394 757 A (MAX PLANCK GESELLSCHAFT) * the whole document * | 6,12-14 | TECHNICAL FIELDS SEARCHED (Int.Cl.6) H01L |
| D,A | US 4 882 609 A (SCHUBERT ERDMANN ET AL) * column 9, line 53 - column 10, line 43; figures 1J,1G * | 1,7 | |
| A | NGUYEN L D ET AL: "INFLUENCE OF QUANTUM-WELL WIDTH ON DEVICE PERFORMANCE OF AL0.30GA0.70AS/INP0.25GA0.75AS (ON GAAS) MODFET'S" IEEE TRANSACTIONS ON ELECTRON DEVICES, vol. 36, no. 5, 1 May 1989, pages 833-838, XP000099014 | 5,11 | |

The present search report has been drawn up for all claims

| Place of search | Date of completion of the search | Examiner |
|---|---|---|
| MUNICH | 24 October 1997 | Eliasson, G |